(19) Europäisches Patentamt
European Patent Office
Office européen des brevets

(11) EP 0 764 851 A1

(12) EUROPEAN PATENT APPLICATION
published in accordance with Art. 158(3) EPC

(43) Date of publication:
26.03.1997 Bulletin 1997/13

(51) Int. Cl.$^6$: G01R 19/165, G01R 31/36

(21) Application number: 96908377.3

(86) International application number:
PCT/JP96/00966

(22) Date of filing: 09.04.1996

(87) International publication number:
WO 96/32651 (17.10.1996 Gazette 1996/46)

(84) Designated Contracting States:
CH DE FR GB IT LI SE

(30) Priority: 10.04.1995 JP 84185/95
11.04.1995 JP 85642/95

(71) Applicants:
• HINO JIDOSHA KOGYO KABUSHIKı KAISHA
Hino-shi Tokyo 191 (JP)
• Japan Storage Battery Co., Ltd.
Kyoto-shi, Kyoto 601 (JP)

(72) Inventors:
• JOKO, Isao
Tokyo 191 (JP)
• KOIKE, Tetsuo
Tokyo 192 (JP)
• YAMAGUCHI, Koichi
Tokyo 194-02 (JP)

• MASUDA, Satoshi
Tokyo 191 (JP)
• ARITAKA, Kiyoshi
Tokyo 194 (JP)
• MASUDA, Atsushi
Tokyo 204 (JP)
• SHIMIZU, Kunitoshi
Tokyo 190 (JP)
• NAKAMURA, Hideji
Osaka 572 (JP)
• MIYAKE, Toshihiko
305 Yamada Building
Kyoto 615 (JP)

(74) Representative: Skone James, Robert Edmund
GILL JENNINGS & EVERY
Broadgate House
7 Eldon Street
London EC2M 7LH (GB)

(54) VOLTAGE DETECTOR

(57) A voltage detector that provides simplified safe means of quickly finding defective ones out of a large mumber of constituent unit cells in a high voltage cell with no skill without touching the individual cells. A voltage detection circuit equipped with a first light emission display circuit is connected fixedly by a pair of connection members. This display lights when a terminal voltage between the terminals of respective unit cells of a high voltage cell constituted by connecting in series a large number (n) of unit cells is or was below a first set value ($V_1$). A second light emission display circuit for emitting light for display in different colors from that of the first light emission display circuit when the terminal voltage exceeds a second set value ($V_2$) may be provided in the voltage detection circuit and in this case, light emitting diodes having a red color are used for the first light emission display circuit, and light emitting diodes having a green color are used for the second light emission display circuit. Since degradation of the unit cell car be detected at an initial stage, the cell life can be increased, and the environmental problem can be improved by eliminating wastes.

Fig.1

EP 0 764 851 A1

## Description

[Technical Field]

This invention is utilized in the maintenance of high-voltage batteries comprising a multiplicity of unit cells connected in series. It is utilized to detect whether the voltage of each unit cell of a high-voltage battery is normal or abnormal. It is suitable for use in electric vehicles, and is utilized in fixed connection to a battery for an electric vehicle, etc. It is utilized as a device which enables the state of a battery housed in a battery compartment to be checked or monitored without coming into contact with a live part.

This invention is a device that was developed for mounting in a hybrid vehicle equipped with the auxiliary acceleration and auxiliary braking device (disclosed in PCT Publication No. WO88/06107) marketed by the present applicant under the name HIMR (Hybrid Inverter controlled Motor and Retarder system). However, it has wide applicability to high-voltage batteries in general.

[Background Technology]

Electric vehicles utilize rechargeable high-voltage batteries with terminal voltages in excess of 100 V. Such batteries are implemented by connecting a multiplicity of low-voltage (e.g., 2 V, 6 V, 12 V, etc.) unit cells in series. With a high-voltage battery of this sort, it would be dangerous for a person to come into direct contact with a battery electrode, and so various safety and protective measures are taken to ensure that neither battery terminals nor unit cell terminals can become exposed, so that a person cannot accidentally come into direct contact with these.

In the prior art, in order to maintain and check a high-voltage battery of this sort, measuring equipment has to be connected to its terminals. Even when it is thought that a defect has occurred in just one or two of a multiplicity of series-connected unit cells, the maintenance and checking of a conventional high-voltage battery has necessitated connecting measuring equipment to the terminals of each unit cell and making a plurality of measurements in order to discover which unit cells are defective. It is therefore stipulated that the maintenance and inspection of such a high-voltage battery has to be carried out by someone who has received a prescribed training and who carefully employs a stipulated safe procedure. This means that maintenance and inspection cannot be performed freely by the driver and that each vehicle has to be taken to a designated vehicle service centre, etc.

With a high-voltage battery of this sort, the internal resistance of the overall battery may rise due to a defect such as electrolyte insufficiency occurring in just a few of the multiplicity of series-connected unit cells. When this happens, it would be easy to restore the situation to normal by performing the appropriate maintenance on those unit cells that are defective. If the construction of the battery is such that it is easy to separate the unit cells, then the situation could be easily returned to normal by replacing just the defective unit cells. However, because there is no easy way of discovering which unit cell is defective, the measure adopted is to replace the entire battery, despite the fact that only some unit cells have become defective. Because a battery in which most of the unit cells are working perfectly is discarded as defective, the result is shortened practical battery life and increased maintenance costs of electric vehicles. There are also the complex environmental problems relating to the disposal of used batteries.

Furthermore, because there is no suitable method of warning the driver of an electric vehicle when only a very few unit cells have become defective and these defects are still slight, what happens is that the battery continues to be used, cycles of charging and discharging are repeated, and the defective state worsens. The end result is shorter battery life.

This invention has been devised in the light of this situation, and its object is to provide a device which can detect deterioration of a unit cell of a high-voltage battery without a person having to touch the battery; a device which even an untrained person can use to detect, quickly and safely, deterioration of unit cells of a high-voltage battery; and a device which can detect the early stages of deterioration of unit cells of a high-voltage battery and give early warning of this. Further objects of this invention are to increase the practical life of a battery, to avoid unnecessary discarding of batteries, and to lessen environmental problems. Another object of this invention to provide a device which enables battery condition to be monitored while the vehicle is being driven.

[Disclosure of the Invention]

The distinguishing feature of this invention is that it detects, in respect of each unit cell of a high-voltage battery comprising a multiplicity of series-connected unit cells, whether that unit cell is normal or abnormal, and transmits and displays this finding either optically or by radio waves.

Namely, a first aspect of this invention is a voltage detection device for a high-voltage battery comprising a multiplicity **n** of series-connected unit cells, said voltage detection device comprising pairs of connectors respectively fixedly connected to the terminals of the aforesaid unit cells, and voltage detection circuits which detect when the aforesaid terminal voltage is at or less than a preset value, and wherein **n** of these voltage detection circuits are connected in series via said connectors.

Each aforesaid voltage detection circuit has a light-emitting display which emits light in accordance with the detection output. It is desirable if said voltage detection circuit has two of the aforesaid preset values ($V_1$, $V_2$) and two light-emitting displays which respectively emit light of a different color in accordance with these two preset values.

According to another constitution, each of the aforesaid voltage detection circuits has an oscillator which radiates radio waves into space, said radio waves having been modulated in accordance with the detection output; and this oscillator stops generating radio waves when the aforesaid terminal voltage exceeds a preset value, and begins generating radio waves when said terminal voltage has fallen below a preset value.

"Modulated in accordance with the detection output" covers a variety of modulation schemes including (i) simply switching on and off, (ii) frequency modulation, and (iii) phase modulation.

If, by way of example, lead storage batteries are used, the "unit cell" may be a 2 volt cell itself, or it may be a 2 x $m$ volt cell (4 V, 6 V, 12 V, etc.) comprising $m$ 2 volt cells connected in series.

A voltage detection circuit is fixedly connected by a pair of connectors between the terminals of each of the multiplicity $n$ of series-connected unit cells. The light-emitting display provided for this voltage detection circuit emits light when the terminal voltage is at or below a first preset value ($V_1$), thereby indicating that the unit cell in question is in an abnormal condition. Each individual unit cell can thus be checked visually for abnormality. As a result, the entire battery can easily be restored to a normal condition by simply replacing any unit cells which are abnormal.

An alternative constitution is to continue the emission of light or generation of radio waves not just in the circumstances described above, i.e., when the terminal voltage has decreased to or less than a preset value, but also when there is a history of the terminal voltage having fallen to or below the preset value. In other words, according to this alternative constitution, once a terminal voltage has decreased to or below a preset value, emission of light or generation of radio waves is continued even when the terminal voltage recovers to a value in excess of the preset value. In this alternative constitution, what is indicated is the fact that the unit cell in question has been in an abnormal condition. In general, when a battery deteriorates its internal resistance increases and therefore if a high load is placed on that battery, its terminal voltage temporarily drops to or below the preset value. When the load decreases, the terminal voltage will recover. Accordingly, a constitution which provides a circuit that holds a history of the terminal voltage having dropped to or below a preset value, and which indicates when there is an output at this holding circuit, constitutes a superior device which can effectively judge that a battery has deteriorated before this deterioration has reached an advanced stage.

Because this detection of abnormalities is performed without touching the high-voltage battery or its live parts, it can be performed safely and quickly by an untrained person. Moreover, because deterioration of unit cells can be discovered at an early stage, battery life can be extended, unnecessary discarding of batteries can be avoided, and environmental problems lessened.

If the voltage detection circuit is provided with a first light-emitting display which indicates an abnormality and a second light-emitting display which indicates a normal condition, then the fact that a unit cell is in a normal condition can also be indicated, by arranging for light of a different colour from that of the first light-emitting display to be emitted when the terminal voltage exceeds a second preset value ($V_2$). It will then be possible to tell explicitly for each individual unit cell whether that cell is normal or abnormal.

It is desirable to use a red light-emitting diode for the first light-emitting display, since this is the one which indicates an abnormal condition. It is desirable to use a green light-emitting diode for the second light-emitting display, since this is the one which indicates a normal condition.

A red light-emitting diode will be lit when the voltage of a unit cell is at or less than the first preset value ($V_1$), and a green light-emitting diode will be lit when the voltage of a unit cell is greater than the second preset value ($V_2$). By setting the second preset value ($V_2$) to below the first preset value ($V_1$), then although both diodes will sometimes be lit simultaneously, it is possible to avoid the situation in which neither the red nor the green light-emitting diode is lit, and whenever a red light-emitting diode is lit, it will be known with certainty that an abnormality has occurred.

A second aspect of this invention is a voltage monitoring device which monitors the voltage of a high-voltage battery, said voltage monitoring device comprising a voltage detection device constituted so that the aforesaid oscillator stops generating radio waves when the aforesaid terminal voltage exceeds the aforesaid preset value, and begins generating radio waves when said voltage has decreased to or less than said preset value, and further comprising one or several receivers which receive the aforesaid radio waves and which is or are common to the aforesaid $n$ voltage detection circuits. Said receiver or receivers can be provided in the battery compartment.

There are two possible constitutions for the oscillators. According to the first, each of the aforesaid oscillators stops generating radio waves when the terminal voltage of the respective unit cell exceeds a preset value, and begins oscillating when said voltage has decreased to or less than the preset value. According to the second, each oscillator employs a circuit which holds the fact that there is a history of the terminal voltage of the respective unit cell having decreased to or below the preset value. In this case, once the terminal voltage has dropped to or below the preset value, the oscillator continues to generate radio waves even after the terminal voltage has recovered.

When one or a small number of receivers common to the plural number $n$ of voltage detection circuits is provided, it is effective if each individual voltage detection circuit has, in addition to an oscillator for generating radio waves, a circuit which gives an optical display.

With such a constitution, when an abnormality is indicated at the common receiver, it is possible to look at the individual voltage detection circuits and to distinguish which of them has become abnormal.

When the aforesaid high-voltage battery is the motive power battery of an electric vehicle, the aforesaid receiver can be fitted in the body of the vehicle. It is desirable if this receiver has a display means which indicates in the driver's cab that the aforesaid radio waves are being received, and for this display means to be a light-emitting display, and for the aforesaid connectors to be designed so that they cannot be connected the wrong way around to the positive and negative terminals of a cell.

Given a constitution wherein a transmitter comprising a voltage detection circuit and an oscillator is fixedly connected to the terminals of a cell using a pair of connectors, and wherein there is a common receiver which receives radio waves from this transmitter, then, when a voltage detection circuit has detected at the oscillator side the fact that a terminal voltage has decreased to or below the preset value, and an oscillator has radiated into space radio waves modulated in accordance with this detection output, the receiver receives these radio waves, demodulates them, and sends the detection output to a light-emitting display means which, in accordance with this output, indicates optically when any one unit cell is in an abnormal state.

Because an abnormality monitoring device of this sort can operate without having to come near to either the high-voltage battery or its live parts, it can be used safely and quickly by an untrained person. Moreover, because deterioration of unit cells can be discovered at an early stage, battery life can be extended, unnecessary discarding of batteries can be avoided, and environmental problems lessened.

It is possible to constitute this invention so that even when the terminal voltage of a unit cell drops to or below the aforesaid preset value due to deterioration, the unit cell can still make the oscillator work. When a battery deteriorates, its internal resistance generally increases and therefore its terminal voltage will drop when there is a large load. However, even if there is a large load and the terminal voltage of a unit cell decreases to a low voltage at which the oscillator will not oscillate, the terminal voltage will recover when the load changes and has become smaller. Accordingly, by using a circuit which holds a history of the terminal voltage having dropped to or below the preset value, and by constituting the oscillators so that they generate radio waves when there is such a history, an indication that a unit cell is deteriorating can be obtained before the deterioration reaches an advanced stage.

A circuit which holds the fact that a terminal voltage has decreased to or below a preset value can be implemented in a variety of ways by utilizing flip-flops. A simple configuration using a thyristor is recommended as the circuit that holds the fact that the terminal voltage has dropped to or below a preset value. A thyristor has the property that once it has become conductive, it stays conductive even if its terminal voltage changes, provided that the terminal voltage does not become zero. Accordingly, a circuit that holds the fact that a terminal voltage has dropped to or below a preset value can be implemented simply and with a small number of components by utilizing a thyristor in the power supply path of the display or oscillator.

A reset circuit can be provided in the circuit which holds the fact that a terminal voltage has dropped to or below a preset value. This reset circuit can be operated to cancel the holding condition.

Although the circuit which holds the fact that the terminal voltage has dropped to or below the preset value can be provided at the oscillator side as described above, it can also be provided at the receiver side. That is to say, when a terminal voltage has dropped to or below a preset value, an oscillator will operate and radio waves will be transmitted, whereupon a display is made after these have been received at the receiver. The invention can be constituted so that even when the terminal voltage of the cell has risen again above the preset value and radio waves cease being generated, the display continues at the receiver once the receiver holds a history of radio waves having been received. This can be implemented for example by inserting a thyristor in the power supply path of the display at the receiver.

The invention can be constituted with the receiver provided either in the battery compartment or in its vicinity, and with the optical display provided in the driver's cab. With this constitution, low power oscillators are sufficient. Furthermore, with this constitution a low-sensitivity receiver is sufficient, which means that interference from other radio waves can be eliminated. With this constitution, because the driver can constantly see the display, an abnormality can be dealt with promptly.

The connectors which connect an oscillator to a unit cell can be constituted so that they cannot be connected the wrong way around to the positive and negative terminals of the cell. Having such a constitution makes it possible to prevent faults due to reverse connection. Faults or deterioration due to rain or surface water can be prevented by housing the transmitter in a waterproof box.

[Brief Explanation of the Drawings]

FIG. 1 is a perspective view showing the overall constitution of a first embodiment of this invention.

FIG.2 is a block diagram showing the overall constitution of a first embodiment of this invention.

FIG.3 is a perspective view showing the constitution of a unit cell in a first embodiment of this invention.

FIG.4 shows the constitution of a voltage detection circuit in a first embodiment of this invention.

FIG.5 shows the constitution of a voltage detection circuit in a second embodiment of this invention.

FIG.6 shows the situation where a red light-emitting diode in a second embodiment of this invention remains lit.

FIG.7 is a block diagram showing the overall constitution of a third embodiment of this invention.

FIG.8 is a perspective view showing the constitution of a unit cell in a third embodiment of this invention.

FIG.9 is a perspective view showing the situation before a transmitter is fitted to a unit cell in a third embodiment of this invention.

FIG.10 is a circuit diagram showing the constitution of a voltage detection circuit in a third embodiment of this invention.

FIG.11 is a perspective view showing a high-voltage battery mounted according to a third embodiment of this invention.

FIG.12 is a plan view of a vehicle showing an example in which a radio receiver and an optical display means have been positioned in the driver's cab in a third embodiment of this invention.

FIG.13 shows an example in which a radio receiver and an optical display means have been positioned in the driver's cab in a third embodiment of this invention.

FIG.14 is a perspective view showing the connectors when a transmitter has been fitted the wrong way round in a third embodiment of this invention.

FIG.15 is a cross-sectional view showing the constitution of a waterproof transmitter in a third embodiment of this invention.

[Optimum Configurations for Embodying the Invention]

Embodiments of this invention will now be explained on the basis of the drawings.

(First embodiment)

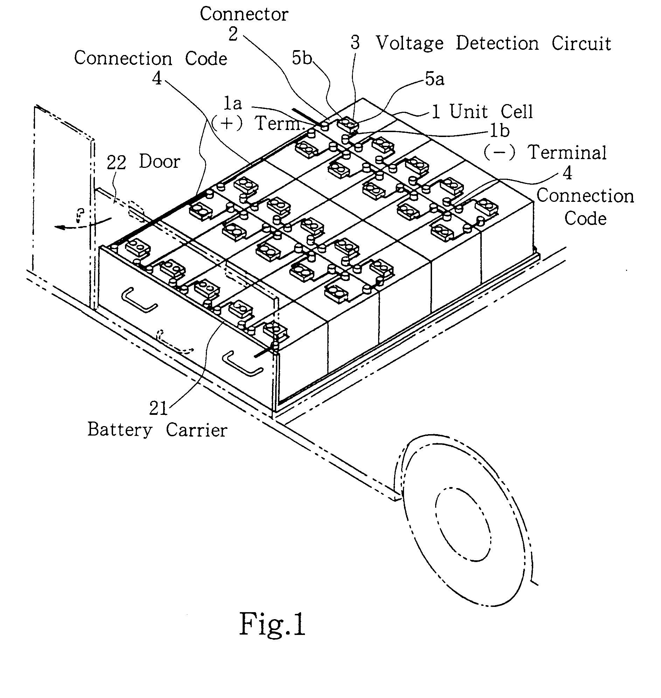

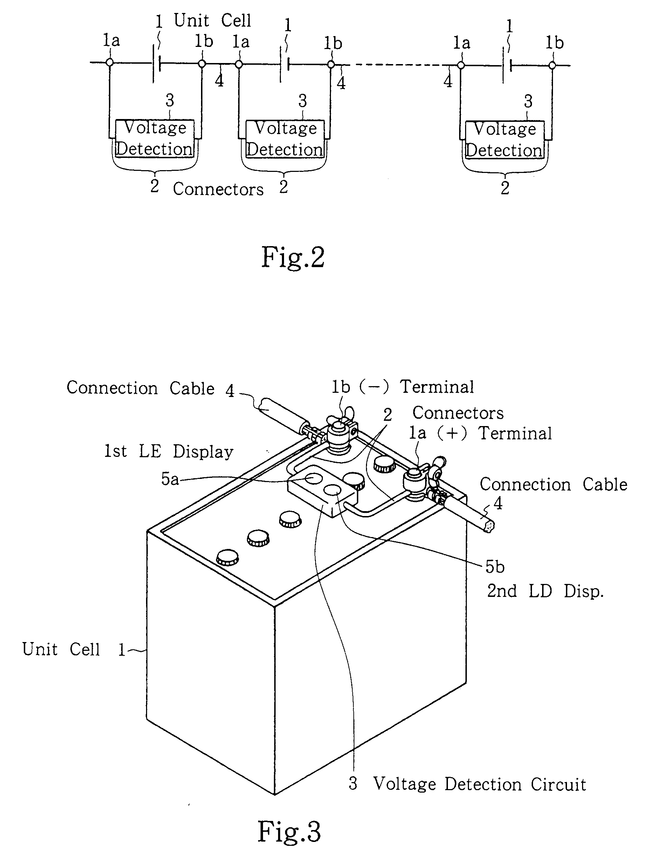

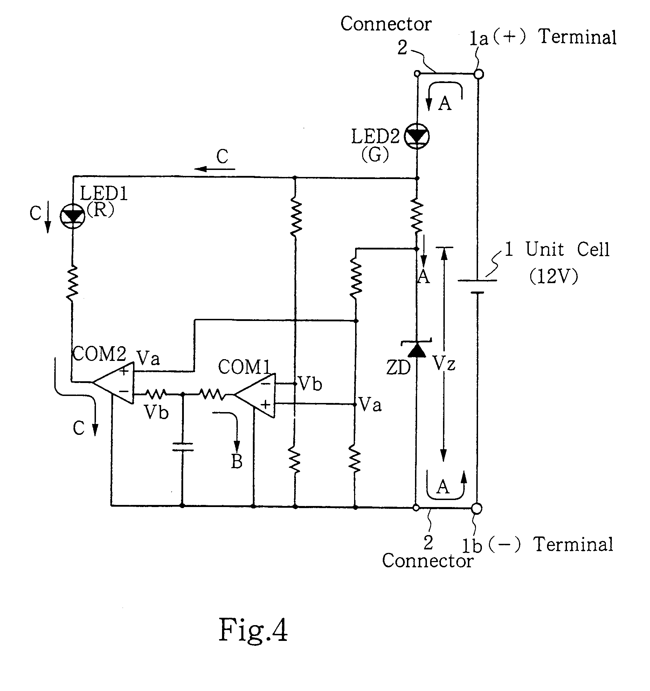

FIG.1 is a perspective view showing the overall constitution of a first embodiment of this invention. FIG.2 is a block diagram showing the overall constitution of this first embodiment. FIG.3 is a perspective view showing the constitution of a unit cell in this first embodiment. FIG.4 shows the constitution of a voltage detection circuit in this first embodiment.

In the first embodiment of this invention, a multiplicity $n$ of unit cells 1 (where n=25) are connected in series; and there are provided for each unit cell 1 a pair of connectors 2 respectively connected fixedly to the (+) terminal 1a and the (-) terminal 1b of the unit cell 1, and a voltage detection circuit 3 which detects when the voltage between (+) terminal 1a and (-) 1b is at or below a preset value; and $n$ of these voltage detection circuits 3 (where n=25) are connected in series via the connectors 2. The (+) terminal 1a of a unit cell 1 and the (-) terminal 1b of an adjacent series-connected unit cell 1 are connected by connection cable 4.

A first preset value ($V_1$) and a second preset value ($V_2$, where $V_2<V_1$) are established as the aforesaid preset values. First light-emitting display 5a and second light-emitting display 5b are provided in voltage detection circuit 3. First light-emitting display 5a indicates by emission of light when the voltage between (+) terminal 1a and (-) terminal 1b is at or below first preset value ($V_1$), and second light-emitting display 5b indicates by emission of light of a different colour from that of first light-emitting display 5a, when the voltage between (+) terminal 1a and (-) terminal 1b exceeds second preset value ($V_2$). First light-emitting display 5a comprises a red light-emitting diode, and second light-emitting display 5b comprises a green light-emitting diode.

In the example shown in FIG.4, red light-emitting diode LED 1 and green light-emitting diode LED 2 are used in voltage detection circuit 3. In this same drawing, COM 1 is a first comparator, COM 2 is a second comparator, and ZD is a Zener diode. Although in this circuit configuration the aforementioned first preset value ($V_1$) and second preset value ($V_2$) of the terminal voltage have been set to the same value, it is also feasible to set second preset value ($V_2$) below first preset value ($V_1$).

As shown in FIG.1, a high-voltage battery mounted according to this first embodiment of the invention comprises twenty-five 12 V unit cells 1 connected in series and housed on battery carrier 21 in a battery compartment provided low down in the middle of a vehicle. It is then shielded from the outside by door 22 which can open and shut.

An explanation will now be given of the display functions of voltage detection circuit 3 according to this first embodiment of the invention, said voltage detection circuit being shown in FIG.4. On the assumption that first preset value $V_1$ = second preset value $V_2 = Vz$, then, when the voltage of 12 V unit cell 1 is greater than preset value Vz, Zener diode ZD will be conductive and a current **A** will flow. As a result, green light-emitting diode LED 2 will light, thereby indicating that there is no abnormality.

When the voltage of unit cell 1 is greater than preset value Vz, voltages Va and Vb which are applied to the input side of first comparator COM 1 are in the relation Va<Vb, and therefore a current **B** flows through first comparator COM 1. As a result, current **C** does not flow through second comparator COM 2, and red light-emitting diode LED 1 does not light.

If the voltage of unit cell 1 becomes less than preset value Vz, Zener diode ZD ceases to be conductive and consequently current **A** disappears. The voltages applied to the input side of first comparator COM 1 will then be in the relation Va>Vb, and a current **B** flows in the negative direction through first comparator COM 1. This flow of current **B** is accompanied by a flow of current **C** through second comparator COM 2, and as a result red light-emitting diode LED 1 lights, thereby indicating that the voltage of unit cell 1 has become less than preset value Vz. Green light-emitting diode LED 2 will also be lit at this time, and the fact that both diodes are thus lit indicates that the voltage detection function has been performed normally, and that as a result an abnormality has been detected.

Voltage detection of this sort is performed automatically and individually for each of the twenty-five unit cells 1. The driver can therefore visually confirm the condition of the high-voltage battery simply by opening door 22 depicted in FIG.1, and without pulling out battery carrier 21. If light-emitting diodes LED 1 and LED 2 of a unit cell are both unlit, the driver can conclude that a connector 2 has not been adequately fitted, or that there is some abnormality in the voltage detection circuit 3.

(Second embodiment)

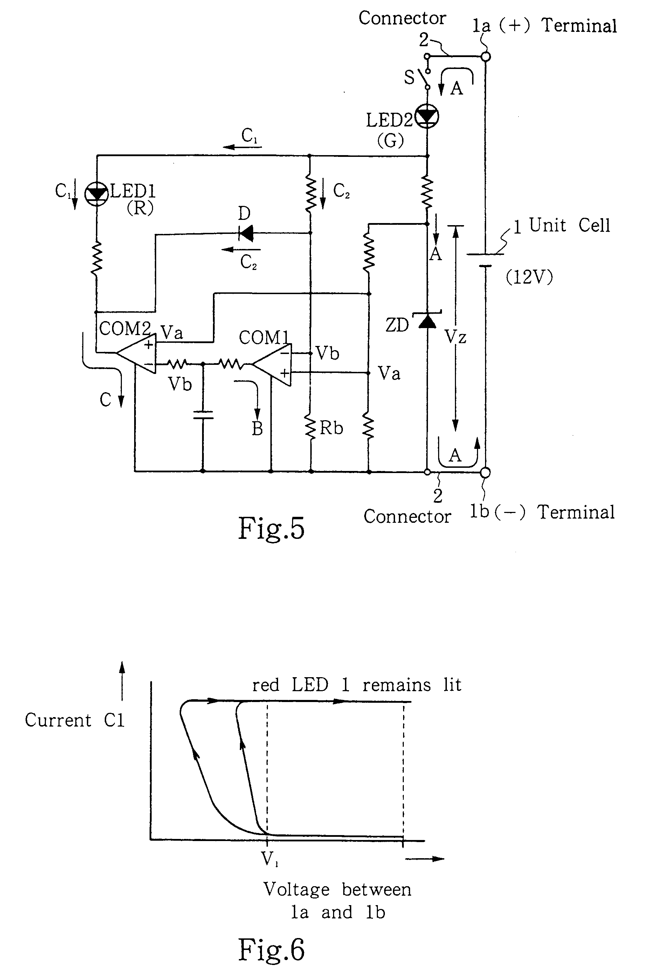

FIG.5 shows the constitution of a voltage detection circuit in a second embodiment of this invention.

In this second embodiment, as in the first embodiment, a multiplicity **n** of unit cells 1 (where n=25) are connected in series; and there are provided for each unit cell 1 a pair of connectors 2 respectively connected fixedly to the (+) terminal 1a and the (-) terminal 1b of the unit cell 1; and **n** voltage detection circuits 3 (where n=25) are connected in series via connectors 2, each voltage detection circuit 3 including a first light-emitting display 5a which indicates by emission of light when there is a history of the voltage between (+) terminal 1a and (-) terminal 1b having decreased to or below a first preset value. The (+) terminal 1a of a unit cell 1 and the (-) terminal 1b of an adjacent series-connected unit cell 1 are connected by connection cable 4, as in the first embodiment.

Voltage detection circuit 3 also has switch S which can be opened or closed by the driver, and diode D. Switch S is provided between (+) terminal 1a and green light-emitting diode LED 2, while diode D is connected between green light-emitting diode LED 2 and second comparator COM 2.

The operation of this second embodiment will now be explained. The lighting of red light-emitting diode LED 1 when an abnormality has occurred in unit cell 1 is performed in the same manner as in the first embodiment, but this second embodiment has a function whereby red light-emitting diode LED 1 is maintained in its lit state.

Namely, after red light-emitting diode LED 1 has lit, it remains lit even if unit cell 1 stops discharging to load, i.e., even if the load current decreases and the voltage of unit cell 1 increases. This is because once red light-emitting diode LED 1 has lit, diode D becomes conductive due to shunt current $C_2$ of main current $C_1$ which flows through red light-emitting diode LED 1. Because diode D is connected in parallel with resistor Rb which generates potential Vb, this potential Vb becomes equal to the forward voltage of diode D, with the result that the relation Va>Vb is maintained.

FIG.6 shows the situation where a red light-emitting diode in a second embodiment of this invention remains lit. If the terminal voltage of a unit cell 1 again becomes greater than a first preset value $V_1$, current $C_1$ will continue flowing due to the mechanism described above, and red light-emitting diode LED 1 will continue to be lit.

Switch S is used to reset the circuit. Replacement of unit cell 1 after red light-emitting diode LED 1 has lit is carried out with switch S open. Once the unit cell has been replaced, switch S is closed. This procedure ensures that red light-emitting diode LED 1 does not remain lit when the power supply circuit is reconnected.

(Third embodiment)

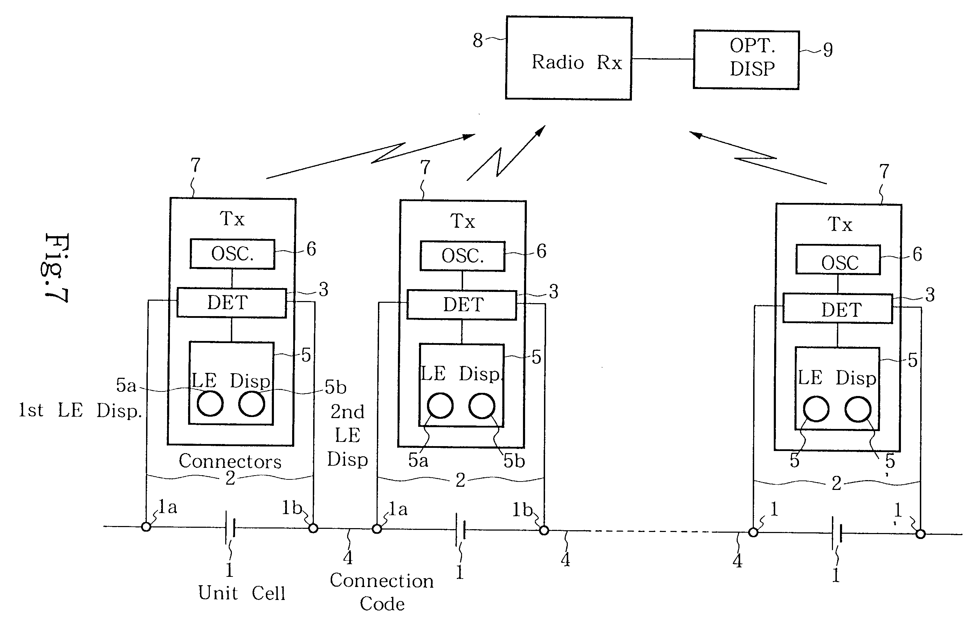

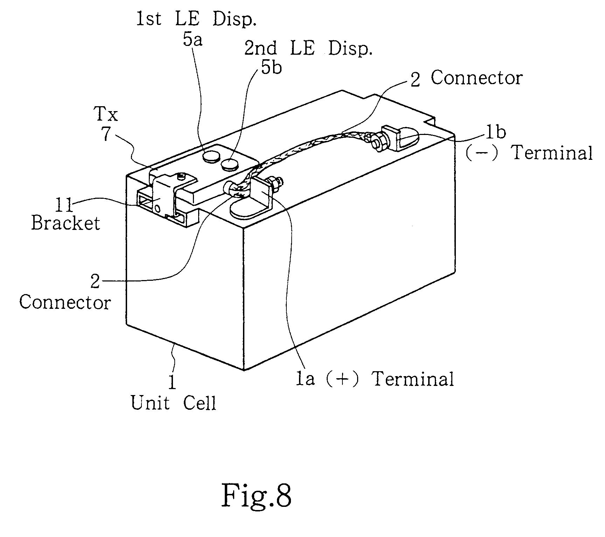

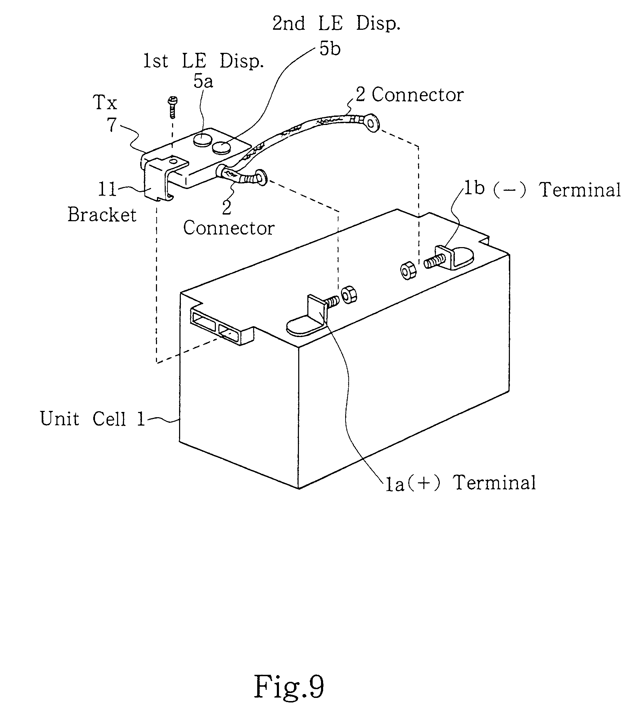

FIG.7 is a block diagram showing the overall constitution of a third embodiment of this invention. FIG.8 is a perspective view showing the constitution of a unit cell in this third embodiment. FIG.9 is a perspective view showing the situation before a transmitter is fitted to a unit cell in this third embodiment.

This third embodiment of the invention comprises a multiplicity **n** of unit cells 1 (where n=25) connected in series; a pair of connectors 2 respectively fixedly connected to the (+) terminal 1a and the (-) terminal 1b of each unit cell 1; and transmitters 7. Each transmitter 7 comprises voltage detection circuit 3 which detects when the voltage between (+) terminal 1a and (-) terminal 1b has dropped to or below a preset value; oscillator 6 which radiates radio waves into space, said radio waves having been modulated in accordance with the detection output of this voltage detection circuit 3; and light-emitting display 5 which indicates, in accordance with the detection output of voltage detection circuit 3, whether unit cell 1 is normal or abnormal. This third embodiment of the invention further comprises radio receiver 8 and optical display means 9. Radio receiver 8 receives the radio waves radiated from an aforesaid transmitter 7 and which have propagated through space, and demodulates the detection output of a voltage detection circuit 3. Optical display means 9 displays the demodulated output from this radio receiver 8.

Transmitter 7 is removably fitted by bracket 11 to unit cell 1 as shown in FIG.8. FIG.9 shows the situation before it is fitted. Oscillator 6 inside transmitter 7 comprises means which stops the generation of radio waves when the voltage between (+) terminal 1a and (-) terminal 1b exceeds a preset value, and which starts the generation of radio waves when this voltage has decreased to or below a preset value. Light-emitting display 5 comprises first light-emitting display 5a which indicates by emission of red light when the voltage between (+) terminal 1a and (-) terminal 1b has decreased to or below a preset value, and second light-emitting display 5b which indicates by emission of green light when the voltage between (+) terminal 1a and (-) terminal 1b exceeds a preset value. The (+) terminal 1a of a unit cell 1 and the (-) terminal 1b of an adjacent series-connected unit cell 1 are connected by connection cable 4.

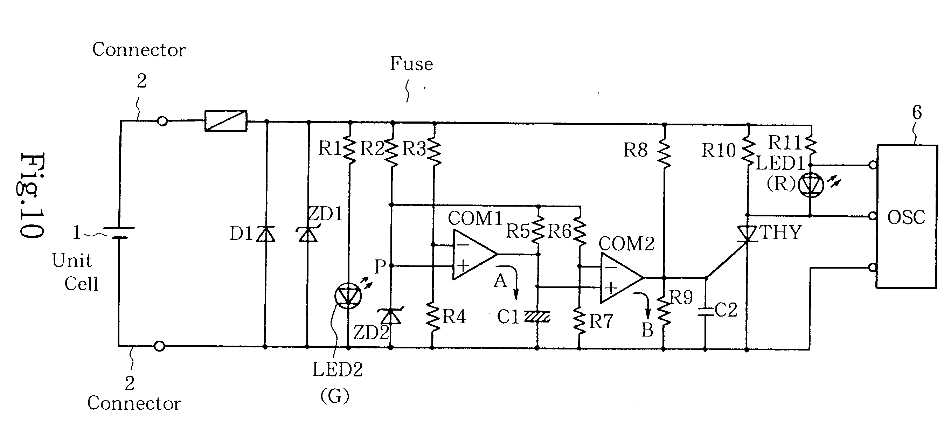

FIG.10 is a circuit diagram showing the constitution of a voltage detection circuit in this third embodiment of the invention. In this example, red light-emitting diode LED 1 and green light-emitting diode LED 2 are used as the light-emitting elements. In this same figure, COM 1 is a first comparator, COM 2 is a second comparator, ZD1 and ZD2 are Zener diodes, and THY is a thyristor.

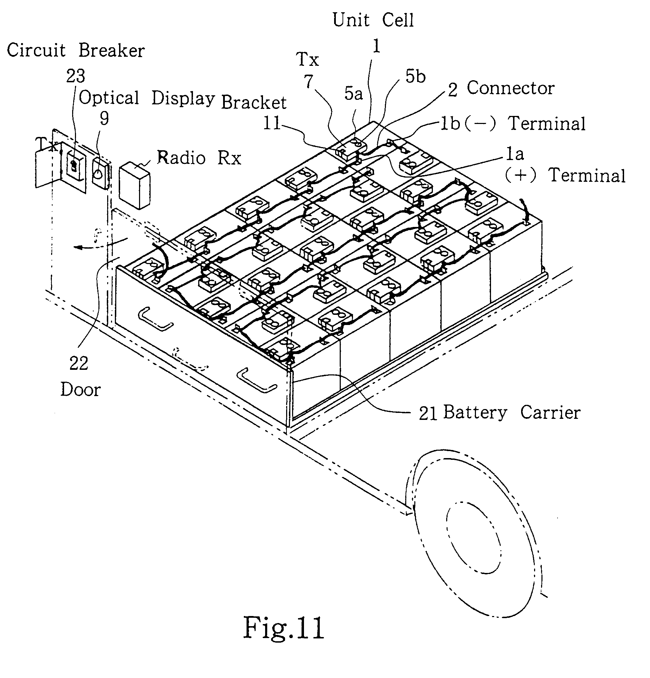

FIG.11 is a perspective view showing a high-voltage battery mounted in accordance with this third embodiment. In this example, twenty-five 12 V unit cells 1 are connected in series and housed on battery carrier 21 in a battery compartment provided low down in the middle of a vehicle. Radio receiver 8, optical display 9 and circuit breaker 23 are positioned in the vicinity of this battery carrier 21, and battery carrier 21 is shielded from the outside by door 22 which can open and shut.

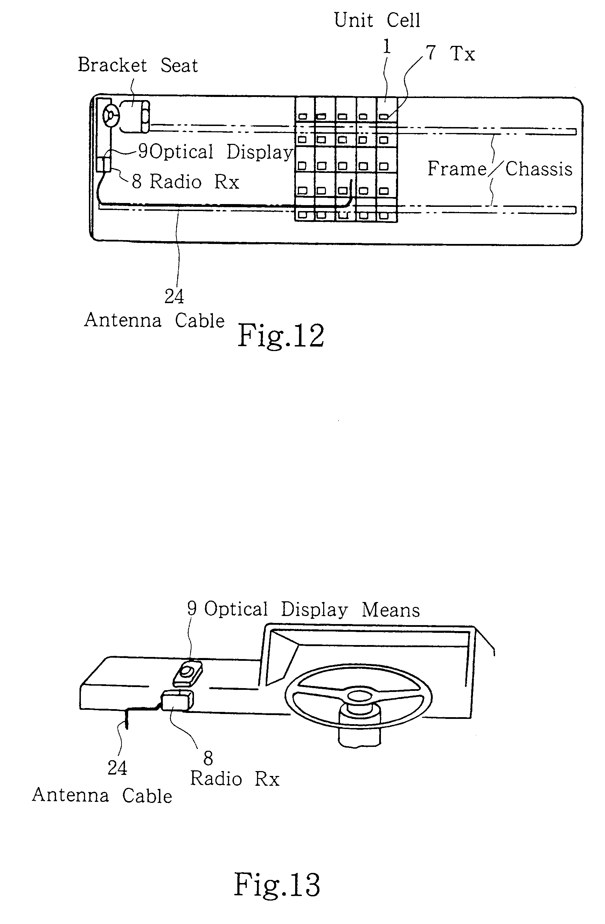

Radio receiver 8 and optical display means 9 can also be positioned in the driver's cab, as shown in FIG.12 and FIG.13. In this case, radio receiver 8 is operated from the vehicle power supply, and the interval between radio receiver 8 and the battery compartment is connected by antenna cable 24. Optical display means 9 is constituted so that a red lamp lights when an abnormality occurs in any one of unit cells 1. If optical display means 9 is positioned in the driver's cab, the driver can constantly monitor it and can therefore take countermeasures immediately an abnormality occurs.

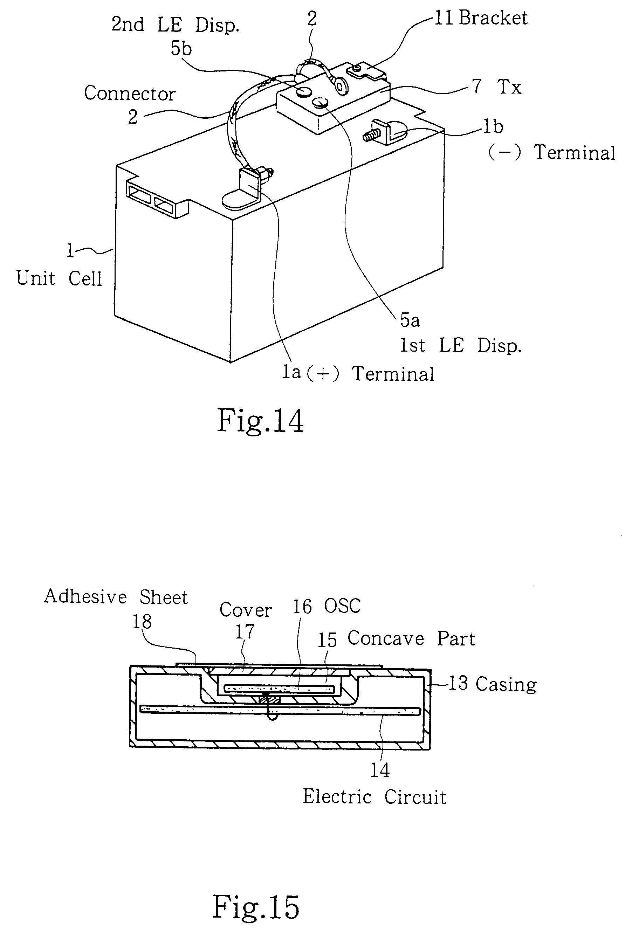

Connectors 2 are constituted so that transmitter 7 cannot be connected the wrong way round. This is achieved by making the length of the cable that connects to the (+) terminal 1a short and the length of the cable that connects to the (-) terminal 1b long. As a result, when fitted in the correct position as shown in FIG.8, both of connectors 2 can be connected, one to (+) terminal 1a and one to (-) terminal 1b. However, if transmitter 7 has been fitted the wrong way round as shown in FIG.14, one of the pair of connectors cannot reach either the (+) terminal 1a or the (-) terminal 1b and therefore cannot be connected, thus preventing transmitter 7 being connected the wrong way round.

Transmitter 7 can also be made waterproof, and FIG.15 is a cross-sectional view showing such a constitution. This waterproof transmitter is made completely waterproof by integrally molding electric circuit 14, which excludes the oscillator, in casing 13, in such a way that the light-emitting display can be seen from the outside. Concave part 15 is formed in the centre of the top surface of casing 13 and oscillator circuit substrate 16 is housed inside this. Concave part 15 is then closed with cover 17, and adhesive sheet 18 stuck on over this. Such a construction enables a completely watertight structure to be achieved without impairing the oscillation function.

An explanation will now be given of the display function of voltage detection circuit 3 and light-emitting display 5 in this third embodiment of the invention, shown in FIG.10. If the voltage of unit cell 1 is equal to or greater than a prescribed value (e.g., 5 V) the current from unit cell 1 will flow through light-emitting diode LED 2 which will light up green, thereby indicating that the condition of the cell is normal. A voltage stabilized by Zener diode ZD2 will appear at point P, and is applied to the non-inverting input of first comparator COM 1. The voltage of unit cell 1 split by resistors R3 and R4 is applied to the inverting input of first comparator COM 1.

The values of resistors R3 and R4 are selected so that when the cell voltage is normal, the voltage split by these resistors will be higher than the voltage at point P that has been stabilized by Zener diode ZD2. Therefore, when the cell voltage is normal, there is no output current A from first comparator COM 1 nor current B from second comparator COM 2. Accordingly, thyristor THY will be in its non-conductive state and red light-emitting diode LED 1 will not light.

If the voltage of unit cell 1 falls below the prescribed value, the voltage split by resistors R3 and R4 becomes lower than the voltage at point P stabilized by Zener diode ZD2. A current A therefore flows at the output of first comparator COM 1, with the result that a current B flows at the output of second comparator COM 2. As a result of this, thyristor THY becomes conductive and red light-emitting diode LED 1 emits light, thereby indicating that the voltage has dropped to or below the prescribed value. Because green light-emitting diode LED 2 is also lit under these circumstances, the fact that both diodes are lit indicates that the voltage detection function has been performed and that as a result an abnormality has been detected.

When the terminal voltage of any of unit cells 1 decreases to or below the prescribed value and red first light-emitting display 5a of light-emitting display 5 has lit in the manner described above, voltage detection circuit 3 sends this detection output to oscillator 6. Oscillator 6 then generates radio waves in accordance with this detection output. These radio waves are received and demodulated by radio receiver 8, and the resulting output is sent to optical display means 9. This then lights up red, thereby giving notification of the fact that an abnormal situation has occurred.

Because this sort of voltage detection function is performed automatically and separately for each of the twenty-five unit cells 1, when the driver is informed by optical display means 9 lighting up, it will be possible to confirm visually which of unit cells 1 is in an abnormal state simply by opening up door 22 shown in FIG.11, and without pulling out battery carrier 21. When a unit cell 1 in which an abnormality has occurred is replaced, the terminal voltage will exceed the prescribed value and hence oscillator 6 ceases to generate radio waves.

Situations may arise in which both light-emitting diodes LED 1 and LED 2 are unlit, but in these circumstances it can be assumed that there is a defect in transmitter 7, including the possibility that a connector 2 has been badly fitted.

## Claims

1. A voltage detection device for a high-voltage battery comprising a multiplicity **n** of unit cells connected in series,

   said voltage detection device comprising pairs of connectors respectively fixedly connected to the terminals of the aforesaid unit cells, and voltage detection circuits which detect that the voltage of the aforesaid terminals is at or less than a preset value; wherein **n** of these voltage detection circuits are connected in series via the aforesaid connectors.

2. A voltage detection device for a high-voltage battery as set forth in Claim 1, wherein the aforesaid voltage detection circuit includes a circuit which holds a history of the aforesaid terminal voltage having decreased to or below the preset value.

3. A voltage detection device for a high-voltage battery as set forth in Claim 1 or 2, wherein each of the aforesaid voltage detection circuits has a light-emitting display which emits light in accordance with the detection output.

4. A voltage detection device as set forth in Claim 3, wherein the aforesaid voltage detection circuit has two of the aforesaid preset values ($V_1$, $V_2$) and two light-emitting displays which respectively emit light of a different colour in accordance with these two preset values.

5. A voltage detection device for a high-voltage battery as set forth in Claim 1 or 2, wherein each of the aforesaid voltage detection circuits has an oscillator which radiates radio waves into space, said radio waves having been modulated in accordance with the detection output.

6. A voltage detection device for a high-voltage battery as set forth in Claim 5, wherein the aforesaid oscillator is constituted so as to stop generating radio waves when the aforesaid terminal voltage exceeds the aforesaid preset value, and to generate radio waves when said terminal voltage has decreased to or below the aforesaid preset value.

7. A voltage detection device for a high-voltage battery as set forth in Claim 5, wherein the aforesaid oscillator is constituted so as to generate radio waves when there is a history of the aforesaid terminal voltage having exceeded the aforesaid preset value.

8. A voltage monitoring device comprising a voltage detection device as set forth in Claim 6 or 7, and one receiver which receives the aforesaid radio waves, and which is common to the aforesaid **n** detection circuits.

9. A voltage monitoring device as set forth in Claim 8, wherein there is provided a display which indicates when there is a history of radio waves having been received at the aforesaid receiver.

10. A voltage monitoring device as set forth in Claim 8 or 9, wherein the aforesaid receiver is provided in the battery compartment.

11. A voltage monitoring device as set forth in Claim 8 or 9, wherein the aforesaid high-voltage battery is a motive power battery of an electric vehicle, the aforesaid receiver is fitted in the body of the vehicle, and there is provided a display means which indicates in the driver's cab that the aforesaid radio waves are being received by the receiver, or that there is a history of their having been received.

12. A voltage monitoring device as set forth in Claim 11, wherein the aforesaid display means is a light-emitting display means.

13. A voltage detection device for a high-voltage battery as set forth in Claim 1, wherein the aforesaid connectors are constructed so that they cannot be connected the wrong way round to the positive and negative terminals of a cell.

Connector
2

Connection Code                       5b          3  Voltage Detection Circuit

4                                                  5a

22 Door          1a          1  Unit Cell
(+) Term.                     1b
                             (−) Terminal
                             4
                             Connection
                             Code

21
Battery Carrier

Fig.1

1a   1 Unit Cell   1   1a   1   1b   1a   1   1b
1b

3   Voltage Detection   3   Voltage Detection   3   Voltage Detection

2   Connectors   2   2

## Fig.2

Connection Cable 4   1b (−) Terminal

2   Connectors
1a (+) Terminal

1st LE Display

5a   Connection Cable
4

5b
2nd LD Disp.

Unit Cell 1

3 Voltage Detection Circuit

## Fig.3

Fig.4

Connector
1a (+) Terminal
2
S    A
LED2 (G)

C₁

C₁  LED1 (R)

D
C̄₂

C₂

1 Unit Cell

A

(12V)

COM2 Va
COM1
Vb

ZD    Vz

Va
Vb
Va

C

Vb

B

Rb

A

2
Connector    1b (−) Terminal

Fig.5

red LED 1 remains lit

Current C1

V₁

Voltage between
1a and 1b

Fig.6

Fig.7

Fig.8

2nd LE Disp.
5b

1st LE Disp.
5a

2 Connector

Tx
7

1b (−) Terminal

11
Bracket

2
Connector

Unit Cell 1

1a(+) Terminal

Fig.9

Fig.10

Fig.11

Unit Cell

Bracket Seat

1  7 Tx

9 Optical Display

8 Radio Rx

Frame/Chassis

24
Antenna Cable  Fig.12

9 Optical Display Means

24
Antenna Cable

8
Radio Rx

Fig.13

2nd LE Disp.
5b

Connector
2

11 Bracket

2

7 Tx

1b
(−) Terminal

1
Unit Cell

5a
1st LE Disp.

1a (+) Terminal

## Fig.14

Adhesive Sheet
18

Cover
17

16 OSC

15 Concave Part

13 Casing

14
Electric Circuit

## Fig.15

## INTERNATIONAL SEARCH REPORT

| International application No. |
|---|
| PCT/JP96/00966 |

### A. CLASSIFICATION OF SUBJECT MATTER

Int. Cl$^6$  G01R19/165, G01R31/36

According to International Patent Classification (IPC) or to both national classification and IPC

### B. FIELDS SEARCHED

Minimum documentation searched (classification system followed by classification symbols)

Int. Cl$^6$  G01R19/165, G01R31/36

Documentation searched other than minimum documentation to the extent that such documents are included in the fields searched

| Jitsuyo Shinan Koho | 1926 – 1996 |
|---|---|
| Kokai Jitsuyo Shinan Koho | 1971 – 1996 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | Microfilm of the specification and drawings annexed to the written application of Japanese Utility Model Application No. 21251/1983 (Laid-open No. 126459/1984)(Japan Storage Battery Co., Ltd.),<br>August 25, 1984 (25. 08. 84),<br>Claim, Figs. 1 to 4 (Family: none) | 1, 3<br>2, 4-13 |
| Y | Microfilm of the specification and drawings annexed to the written application of Japanese Utility Model Application No. 65156/1985 (Laid-open No. 181382/1986)(Toshiba Corp.),<br>November 12, 1986 (12. 11. 86),<br>Claim, Figs. 1, 2 (Family: none) | 2 |
| Y | JP, 62-124566, U (Kanegafuchi Chemical Industry Co., Ltd.),<br>August 7, 1987 (07. 08. 87),<br>Claim, Figs. 1, 2 (Family: none) | 4 |
| Y | Microfilm of the specification and drawings | 5, 6 |

| [X] Further documents are listed in the continuation of Box C. | [ ] See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
|---|---|
| June 27, 1996 (27. 06. 96) | July 9, 1996 (09. 07. 96) |

| Name and mailing address of the ISA/ | Authorized officer |
|---|---|
| Japanese Patent Office | |
| Facsimile No. | Telephone No. |

Form PCT/ISA/210 (second sheet) (July 1992)

## INTERNATIONAL SEARCH REPORT

| | International application No. |
|---|---|
| | PCT/JP96/00966 |

**C (Continuation).   DOCUMENTS CONSIDERED TO BE RELEVANT**

| Category* | Citation of document, with indication, where appropriate, of the relevant passages | Relevant to claim No. |
|---|---|---|
| A | annexed to the written application of Japanese Utility Model Application No. 178900/1987 (Laid-open No. 84077/1989)(Secom Co., Ltd.), June 5, 1989 (05. 06. 89), All of the specification and drawings (Family: none)<br><br>JP, 55-113277, A (Yuasa Battery Co., Ltd.), September 1, 1980 (01. 09. 80), Lines 2 to 12, lower right column, page 1, lines 14 to 19, upper left column, page 3 (Family: none) | 11 |

Form PCT/ISA/210 (continuation of second sheet) (July 1992)

21